**Europäisches Patentamt**

**European Patent Office**

**Office européen des brevets**

(11) Veröffentlichungsnummer: **0 405 056**

**A2**

## (12) EUROPÄISCHE PATENTANMELDUNG

(21) Anmeldenummer: 90103309.2

(22) Anmeldetag: 21.02.90

(51) Int. Cl.⁵: **H03F 1/02, H03F 3/195**

(30) Priorität: 28.06.89 DE 3921067

(43) Veröffentlichungstag der Anmeldung:
**02.01.91 Patentblatt 91/01**

(84) Benannte Vertragsstaaten:
**DE DK ES FR NL**

(71) Anmelder: **ROBERT BOSCH GMBH**
**Postfach 10 60 50**
**D-7000 Stuttgart 10(DE)**

(72) Erfinder: **Müller, Wolfgang, Dipl.-Ing.**
**Weimarer Strasse 19**
**D-1000 Berlin 12(DE)**

(74) Vertreter: **Schmidt, Hans-Ekhardt, Dipl.-Ing.**
**Robert Bosch GmbH Geschäftsbereich**
**Mobile Kommunikation Patent- und**
**Lizenzabteilung Forckenbeckstrasse 9-13**
**D-1000 Berlin 33(DE)**

(54) **Endverstärker zur Endverteilung von TV-Programmen.**

(57) Es wird ein Endverstärker zur Endverteilung von TV-Programmen vorgeschlagen, der als Breitbandverstärker ausgebildet ist. Für die Versorgung der unterschiedlichen Stufen des Verstärkers sind mindestens zwei interne Betriebsspannungen vorgesehen und die einzelnen Stufen, zumindest die End- und Treiberstufen besitzen eine aktive Arbeitspunkteinstellung bzw. einen aktiven Bias.

EP 0 405 056 A2

# ENDVERSTÄRKER ZUR ENDVERTEILUNG VON TV-PROGRAMMEN

Die Erfindung betrifft einen Endverstärker zur Endverteilung von TV-Programmen nach dem Oberbegriff des Hauptanspruchs.

Ein Verteilnetz für die Verteilung von TV-Programmen weist als aktive Komponenten eine Rükkumsetzerstelle, einen Boosterverstärker, einen Gruppenverstärker und einen Endverstärker auf. Der in diesem Verteilnetz verwendete Endverstärker nach dem Stand der Technik ist als Splitbandverstärker aufgebaut, der in zwei Bereichen, dem UHF- und dem VHF-Bereich arbeitet. Dieser Verstärker hat aber den Nachteil, daß eine Übertragungslücke zwischen VHF-und UHF-Bereich auftritt.

Der Erfindung liegt daher die Aufgabe zugrunde, einen Endverstärker für die Endverteilung von TV-Programmen zu schaffen, der keine Übertragungs lücken hat und eine kleine Leistungsaufnahme bei hoher Nutzleistungsabgabe aufweist.

Diese Aufgabe wird erfindungsgemäß durch die kennzeichnenden Merkmale des Hauptanspruchs gelöst.

Dadurch, daß der Endverstärker als Breitbandverstärker ausgebildet ist, wobei mindestens zwei interne Betriebsspannungen zur Versorgung der unterschiedlichen Stufen vorgesehen sind und zumindest die End- und Treiberstufen eine aktive Arbeitspunkteinstellung (aktiver Bias) besitzen, ist die Leistungsaufnahme äußerst gering, da durch die unterschiedlichen Betriebsspannungen eine Anpassung an die von den einzelnen Stufen benötigten Spannungsversorgungen vorgenommen werden kann und da durch den aktiven Bias keine hohen Querströme für die Arbeitspunktstabilisierung und somit eine geringe Gleichstromleistungsaufnahme notwendig sind. Aufgrund der niedrigen Leistungsaufnahme ist die für die bei der Endverteilung vorgesehenen Endverstärker notwendige Fernspeisung problemlos.

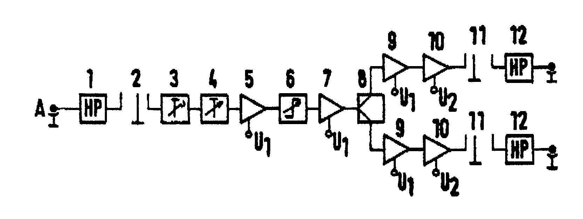

Ein Ausführungsbeispiel der Erfindung ist in der Zeichnung dargestellt und wird in der nachfolgenden Beschreibung näher erläutert. Die einzige Figur zeigt das Blockschaltbild eines Endverstärkers.

Im dargestellten Ausführungsbeispiel ist der Eingang A mit einem Hochpaß 1 für den Rückweg verbunden, der an ein Entzerrersteckfeld 2 angeschlossen ist. Weiterhin sind daran anschließend zwei Dämpfungsglieder 3, 4 vorgesehen, die als Festdämpfer 3 und als stufenloser Dämpfungssteller 4 ausgebildet sind. Die Dämpfungsglieder sind mit einer HF-Vorstufe 5 verbunden, dessen Ausgang über ein stufenloses Schräglagenstellglied 6 an eine HF-Vortreiberstufe 7 angeschlossen ist. Es sind zwei Endstufenzüge vorgesehen, die über einen Verteiltransformator 8 angesteuert werden und jeweils eine HF-Treiberstufe 9, eine HF-Endstufe 10, ein Ausgangsentzerrersteckfeld 11 und einen Hochpaß für den Rückweg 12 aufweist. An den Ein- und Ausgängen kann noch je ein nicht dargestellter Tiefpaß für den Rückweg vorgesehen sein.

Der Endverstärker arbeitet mit zwei Betriebsspannungen $U_1$, $U_2$, wobei die HF-Endstufen mit einer Spannung $U_2$ in der Größenordnung von 20 Volt und die Treiberstufe 9, die Vortreiberstufe 7 und die Vorstufe 5 einer Spannungsversorgung $U_1$ von ca. 12 V haben.

Der Verstärker ist als Breitbandverstärker ausgebildet und hat einen Frequenzbereich von 47 bis 860 MHz (vorwärts) und rund 5 bis 23 MHz (rückwärts). Es werden Eintaktschaltungen verwendet, wobei durch geeignete Transistoren es möglich ist, einen noch ausreichenden 2nd Order-Abstand einzuhalten. Bei dem Breitbandverstärker fallen nämlich die 2nd Order-Störungen in das Übertragungsband und der geforderte Störabstand muß allein von den aktiven Stufen aufgebracht werden. Die Eintaktschaltungen unterstützen die Forderung nach geringer Gleichstromleistungsaufnahme.

Die HF-Transistoren der Verstärker der Stufen 5, 7, 9, 10 oder zumindest der Endstufen 10 und der Treiberstufen 9 weisen eine aktive Arbeitspunkteinstellung, d.h. einen aktiven Bias auf, wobei die aktive Arbeitspunkteinstellung unterschiedlich realisiert werden kann. Im Ausführungsbeispiel erfolgt die Einstellung jeweils über den HF-Transistoren vorgeschaltete Transistoren. Durch die aktive Arbeitspunkteinstellung werden die Querströme stark reduziert.

## Ansprüche

1. Endverstärker zur Endverteilung von TV-Programmen mit mindestens einer HF-Vorstufe, einer HF-Treiberstufe und einer HF-Endstufe, **dadurch gekennzeichnet,** daß er als Breitbandverstärker ausgebildet ist und daß mindestens zwei interne Betriebsspannungen zur Versorgung der unterschiedlichen Stufen (5,7,9,10) vorgesehen sind und zumindest die End- und Treiberstufen (10,9) eine aktive Arbeitspunkteinstellung (aktiver Bias) besitzen.

2. Endverstärker nach Anspruch 1, dadurch gekennzeichnet, daß er als Eintaktschaltung aufgebaut ist.

3. Endverstärker nach Anspruch 1 oder 2, dadurch gekennzeichnet, daß die aktive Arbeitspunkteinstellung über den HF-Transistoren der Stufen vorgeschaltete Transistoren erfolgt.

V31→    0707382024;# 3

BE 21